# EUROPÄISCHE PATENTSCHRIFT

(11) **EP 1 644 990 B1**
(45) Veröffentlichungstag und Bekanntmachung des Hinweises auf die Patenterteilung: **23.04.2014**
(21) Anmeldenummer: 04738883.0
(22) Anmeldetag: 07.07.2004
(51) Int. Cl.: H01L 33/50, H01L 33/44

(54) **LICHT EMITTIERENDES BAUELEMENT MIT EINEM LUMINESZENZ-KONVERSIONSELEMENT**
LIGHT-EMITTING COMPONENT PROVIDED WITH A LUMINESCENCE CONVERSION ELEMENT
COMPOSANT EMETTANT DE LA LUMIERE, POURVU D'UN ELEMENT DE CONVERSION DE LUMINESCENCE

(30) Priorität: 14.07.2003 EP 03015972; 30.12.2003 DE 10361661
(43) Veröffentlichungstag der Anmeldung: 12.04.2006
(73) Patentinhaber: OSRAM Opto Semiconductors GmbH, 93055 Regensburg (DE)
(72) Erfinder: BRAUNE, Bert, 93173 Wenzenbach (DE); WAITL, Günter, 93049 Regensburg (DE)
(74) Vertreter: Epping - Hermann - Fischer
(86) Internationale Anmeldenummer: PCT/DE2004/001464
(87) Internationale Veröffentlichungsnummer: WO 2005/008789

(56) Entgegenhaltungen:
- EP-A- 0 659 820
- EP-A- 1 369 935
- EP-A- 1 403 934
- WO-A-98/54929
- WO-A-02/089175
- WO-A-03/038912
- DE-A1- 10 142 009
- US-A- 5 817 160
- US-A- 5 962 971
- US-A1- 2002 084 748

## Beschreibung

Die Erfindung betrifft ein Licht emittierendes Bauelement mit mindestens einer Primärstrahlungsquelle, die bei Betrieb eine elektromagnetische Primärstrahlung emittiert, und mindestens einem Lumineszenz-Konversionselement, mittels dem zumindest ein Teil der Primärstrahlung in eine Strahlung von veränderter Wellenlänge konvertiert wird.

Ein derartiges Bauelement ist beispielsweise in der DE 101 33 352 A1 beschrieben. Als Primärstrahlungsquelle dient mindestens eine Lumineszenz-Diode, die eine Primärstrahlung im Bereich 300 bis 485 nm emittiert, wobei die Primärstrahlung durch Leuchtstoffe teilweise oder vollständig in längerwellige Strahlung konvertiert wird. Bauelemente, bei denen eine Primärstrahlung aus dem UV- oder UV-nahen Bereich in sichtbares Licht umgewandelt wird, sind insbesondere geeignet, um mittels verschiedenen Leuchtstoffmaterialien weißes Licht mit einer hohen Farbwidergabe zu erzeugen.

Ein Nachteil derartiger Bauelemente kann sein, dass sie eine nicht zu vernachlässigende Restemission von Primärstrahlung aus dem UV- oder UV-nahen Spektralbereich aufweisen. Dies kann insbesondere bei einer Verwendung von Hochleistungslumineszenzdioden als Primärstrahlungsquelle der Fall sein. Eine derartige Restemission ist jedoch möglichst zu vermeiden, da eine elektromagnetische Strahlung aus dem UV- oder aus dem sichtbaren UV-nahen Wellenlängenbereich bei intensiver Einwirkung eine schädigende Wirkung für das menschliche Auge haben kann. Strahlung aus dem UV-Bereich bzw. im violetten Bereich (400 nm - 420 nm) kann in Abhängigkeit von einer auf ein Auge auftreffenden Strahlungsleistung zu einer Schädigung des Auges führen. Für Wellenlängen unterhalb 400 nm dominiert hierbei die Kataraktbildung, d.h. eine Trübung der Augenlinse. Für Wellenlängen zwischen 400 nm und 420 nm kann es zusätzlich zu photochemischer Degradation der Netzhaut kommen.

Die Druckschrift US 5 962 971 A beschreibt ein Licht emittierendes Bauelement nach dem Oberbegriff des Patentanspruchs 1.

Die Druckschriften WO98/54929A, DE 101 42 009 A1, US 2002/084748 A1 und WO 02/089175 A beschreiben ebenfalls Licht emittierende Bauelemente.

Eine Aufgabe der vorliegenden Erfindung ist, ein Licht emittierendes Bauelement anzugeben, das Mittel für eine zumindest teilweise Verringerung einer Strahlungsintensität einer unerwünschten Strahlung aufweist.

Diese Aufgabe wird durch ein Bauelement gemäß Patentanspruch 1 gelöst. Bevorzugte Weiterbildungen und vorteilhafte Ausgestaltungen der Erfindung sind Gegenstand der abhängigen Ansprüche.

Erfindungsgemäß ist bei einem Bauelement der eingangs genannten Art dem Lumineszenz-Konversionselement in einer Abstrahlrichtung des Bauelementes ein Filterelement mit einer Vielzahl von Nanopartikeln nachgeordnet. Die Nanopartikel sind in einem Matrixmaterial eingebettet und weisen eine dispersionsfördernde Oberflächenbeschichtung oder eine dispersionsfördernde Oberflächenmodifikation und eine Filtersubstanz auf, die eine Strahlungsintensität zumindest eines spektralen Bereichs einer unerwünschten Strahlung der Primärstrahlungsquelle durch Absorption selektiv verringert.

Unter Nanopartikeln sind im Zusammenhang mit der Erfindung Partikel mit einem mittleren Partikeldurchmesser von größer oder gleich 0,1 nm und kleiner oder gleich 100 nm zu verstehen.

Nanopartikel haben, verglichen mit einer Wellenlänge von sichtbarer Strahlung, eine relativ kleine Ausdehnung. Dadurch wird sichtbare Strahlung an den Nanopartikeln im wesentlichen nicht inelastisch gestreut, sondern es findet eine Rayleigh-Streuung statt, durch die sichtbare Strahlung nahezu ohne Energieverlust gestreut wird. Somit wird durch das Filterelement im wesentlichen eine Strahlungsintensität nur desjenigen Wellenlängenbereiches einer in dem Bauelement erzeugten elektromagnetischen Strahlung verringert, für den die Filtersubstanz absorbierend ist. Dadurch kann die Strahlungsintensität zumindest eines Teils der unerwünschten Strahlung selektiv verringert werden.

Der Begriff "unerwünschte Strahlung" impliziert im Zusammenhang mit der Erfindung nicht, dass diese Strahlung absolut unerwünscht ist, sondern dass eine Emission dieser Strahlung aus dem Bauelement unerwünscht ist und folglich so weit wie möglich vermieden werden soll.

Bevorzugt stammt die unerwünschte Strahlung aus einem Wellenlängenbereich von kleiner oder gleich 420 nm und größer oder gleich 10 nm oder überlappt mit diesem.

In einer weiteren Ausführungsform des Bauelementes weist die Primärstrahlungsquelle bevorzugt mindestens eine Lumineszenz-Diode auf, die bei Betrieb UV-Strahlung und/oder blaues Licht emittiert. Die Strahlungsintensität des spektralen Teilbereichs der unerwünschten Strahlung wird bevorzugt um mindestens 50 % verringert.

Um eine inelastische Streuung von einer erwünschten Strahlung an den Nanopartikeln weitestgehend zu vermeiden, weisen die Nanopartikel mit Vorteil einen d₅₀-Wert auf, der, in Q₀ gemessen, kleiner oder gleich 25 nm, bevorzugt kleiner oder gleich 21 nm und größer oder gleich 1 nm ist.

Dabei sind die zur Charakterisierung von Partikelgrößen allgemein gültigen Bezeichnungen d₅₀ und Q₀ dem Fachmann bekannt. Q₀ bezeichnet die Verteilungssumme der Häufigkeitsverteilung von Durchmessern d der Partikel eines Ensembles. Der d₅₀-Wert wird auch Mediandurchmesser genannt. 50% der Partikel des Ensembles weisen in Q₀ einen Durchmesser auf, der kleiner als d₅₀ ist, und 50% der Partkiel weisen einen Durchmesser auf, der größer als d₅₀ ist.

Besonders bevorzugt weisen die Nanopartikel einen d₅₀-Wert auf, der, in Q₀ gemessen, kleiner oder gleich 1/20 einer minimalen Wellenlänge der erwünschten Strahlung und größer oder gleich 1 nm ist. In einer besonders vorteilhaften Ausführungsform hiervon weisen alle Nanopartikel einen mittleren Durchmesser auf, der maximal 1/20 einer minimalen Wellenlänge der erwünschten Strahlung beträgt.

Eine bevorzugte Ausführungsform sieht vor, dass mindestens ein Material aus der Gruppe bestehend aus der Materialgruppe der Metalloxide, der Materialgruppe der Sulfide, der Materialgruppe der Nitride und der Materialgruppe der Silikate in der Filtersubstanz enthalten ist. Dabei ist es im Sinne der Erfindung auch möglich, dass das Filterelement mehrere Teilgruppen von Nanopartikeln mit unterschiedlichen Filtersubstanzen aufweist. In einem solchen Fall muss nur die Filtersubstanz mindestens einer der Teilgruppen der Nanopartikel die Bedingungen der Erfindung oder ihrer Ausführungsformen erfüllen.

Die Filtersubstanz weist besonders bevorzugt mindestens ein Material aus der Gruppe bestehend aus Titandioxid, Cerdioxid, Zirkoniumdioxid, Zinkoxid, Wolframoxid, Zinksulfid und Galliumnitrid auf.

Die Nanopartikel sind in einem Matrixmaterial eingebettet, das bevorzugt unempfindlich gegenüber UV-Strahlung ist. Hierzu weist das Matrixmaterial mit Vorteil mindestens ein Material aus der Gruppe bestehend aus Silikon, Spin-on-Gläser, Silizium-Verbindung und Polymer auf.

Um eine möglichst geringe Sedimentierung von Nanopartikeln in dem Matrixmaterial zu erreichen, sind die Nanopartikel mit einer dispersionsfördernden Oberflächenbeschichtung oder Oberflächenmodifikation versehen, durch die ihre Dispergierbarkeit in dem Matrixmaterial verbessert ist.

Weitere Merkmale, Vorteile und Zweckmäßigkeiten der Erfindung ergeben sich aus dem im folgenden in Verbindung mit den Figuren 1 bis 2b beschriebenen Ausführungsbeispielen. Es zeigen:
- Figur 1: eine schematische Schnittansicht eines Ausführungsbeispieles des Bauelementes,
- Figur 2a: ein berechnetes Transmissionsspektrum eines Filterelementes mit Mikropartikeln, und
- Figur 2b: ein berechnetes Transmissionsspektrum eines Ausführungsbeispieles eines Filterelementes gemäß der Erfindung.

In den Ausführungsbeispielen und Figuren sind gleiche oder gleich wirkende Bestandsteile jeweils mit den gleichen Bezugszeichen versehen. Die dargestellten Elemente der Figuren sind nicht als maßstabsgerecht anzusehen, vielmehr können sie zum besseren Verständnis teilweise übertrieben groß dargestellt sein.

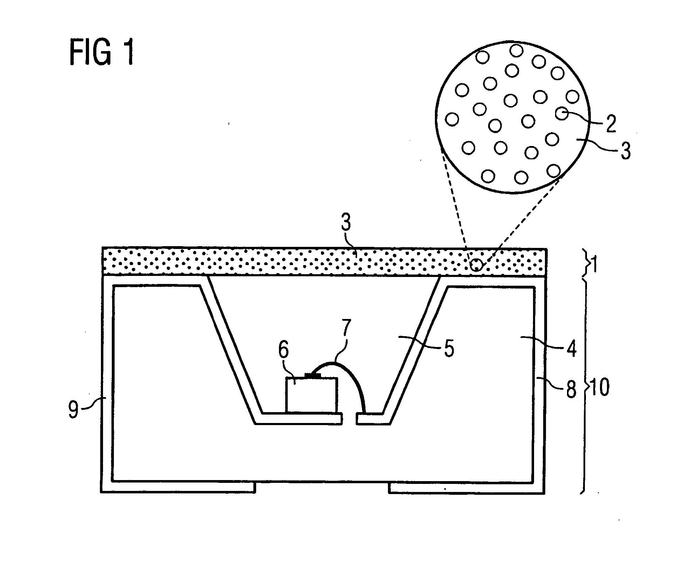

Bei dem in Figur 1 gezeigten Ausführungsbeispielen ist ein Filterelement 1 auf eine Strahlungsauskoppelfläche eines herkömmlichen Gehäuses 10 für Lumineszenzdioden aufgebracht. Das Gehäuse 10 weist eine "Toplooker"-Bauform auf und umfasst eine Gehäusegrundform 4 sowie eine erste und eine zweite elektrisch leitfähige Beschichtung 8, 9, die Wände der Gehäusegrundform 4 teilweise bedecken. Eine Lumineszenzdiode 6 ist auf der zweiten elektrisch leitenden Beschichtung 9 montiert und dadurch mit dieser elektrisch leitend kontaktiert. Die von der elektrisch leitenden Beschichtung 9 abgewandte Seite des Lumineszenzdiodenchips 6 ist mittels eines Bonddrahtes 7 mit der zweiten elektrisch leitenden Beschichtung 8 elektrisch leitend verbunden. Die elektrisch leitfähige Beschichtung ist z.B. für eine von dem Lumineszenzdiodenchip 6 bei dessen Betrieb emittierte elektromagnetische Strahlung reflektierend.

Der Lumineszenzdiodenchip 6 weist eine auf einem Substrat angeordnete, epitaktisch gewachsene Halbleiterschichtenfolge auf, die eine bei Betrieb des Lumineszenzdiodenchips 6 elektromagnetische Strahlung emittierende aktive Zone umfaßt (nicht gezeigt). Die Dicke der Halbleitenschichtenfolge kann beispielsweise 8 *µ*m betragen.

Eine solche Halbleiterschichtenfolge kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden von daher an dieser Stelle nicht näher erläutert. Ein Beispiel für eine Mehrfach-Quantentopfstruktur auf der Basis von GaN ist in der WO 01/39282 A2 beschrieben.

Die Halbleiterschichtenfolge des Lumineszenzdiodenchips 6 basiert beispielsweise auf InAlGaN, d.h. sie enthält mindestens ein Material der Zusammensetzung InₓAl_{y}Ga_{1-x-y}N mit 0 s x ≤ 1, 0 ≤ y ≤ 1 und x + y s 1. Sie emittiert eine elektromagnetische Strahlung, beispielsweise Wellenlängen aus dem UV-Bereich umfasst.

Der Lumineszenzdiodenchip 6 ist von einem Lumineszenz-Konversionselement 5 eingekapselt, das beispielsweise eine auf Silikon basierende Vergußmasse sowie einen oder mehrere darin dispergierte Leuchtstoffe aufweist. Ein Vorteil der Verwendung eines im UV-Bereich emittierenden Lumineszenzdiodenchips als Primärstrahlungsquelle zum Anregen von Leuchtstoffen ist, dass ein von Leuchtstoffen emittiertes Licht in der Regel ein breiteres Spektrum als ein von Lumineszenzdioden emittiertes Licht aufweist. Somit läßt sich beispielsweise weißes Licht mit einer Farbwiedergabe erzeugen, die im Vergleich mit Bauelementen, bei denen Primärsterahlung einen signifikanten Anteil des emittierten Lichtes ausmacht, verbessert ist.

Die in dem Lumineszenz-Konversionselement 5 enthaltenen Leuchtstoffe absorbieren einen Großteil der von dem Lumineszenzdiodenchip 6 emittierten Strahlung, die Wellenlängen aus dem UV-Bereich aufweist, und emittieren daraufhin eine Strahlung mit größeren Wellenlängen. Die von den verschiedenen Leuchtstoffen emittierten Strahlungen durchmischen sich und ergeben Licht eines bestimmten Farbortes der CIE-Farbtafel, insbesondere weißes Licht. Mögliche Leuchtstoffe sind beispielsweise Leuchtstoffpartikel auf der Basis von YAG:Ce, YAG:Tb oder andere geeignete anorganische oder organsiche Leuchtstoffpartikel, die dem Fachmann als UV-anregbar bekannt sind.

Das Filterelement 1 weist ein Matrixmaterial 3 auf, das mit Nanopartikeln 2 versetzt ist. Das Matrixmaterial basiert beispielsweise auf Silikon, kann alternativ aber auch ein durch Spincoating aufgebrachtes Glas, eine Siliziumverbindung oder etwa ein UV-stabiles Polymer, wie es bei Wellenleitermaterialien üblich ist, sein.

Die Nanopartikel 2 weisen beispielsweise als Filtersubstanz TiO₂ auf, welches in verschiedenen Modifikationen vorliegen kann. In der Anatas-Modifikation hat Titandioxid beispielsweise eine Bandlückenenergie von 3,2 eV, was einer Wellenlänge von 387 nm entspricht. In einem Wellenlängenbereich beginnend bei etwa 400 nm bis etwa 380 nm ändert sich der Absorptionskoeffizient von Titandioxid in der Anatas-Modifikation, um mehr als 2 Größenordnungen.

Alternativ kann die Filtersubstanz auch Titandioxid in der Rutil-Modifikation aufweisen, das beispielsweise mit einer Konzentration von ca. 15 Gew.% in dem Filterelement 1 enthalten ist, wobei das Filterelement in einer 50 *µ*m dicken Schicht vorliegt. Das Titandioxid liegt z.B. in Form von Partikeln vor, die einen d₅₀-Wert von 17 nm aufweisen.

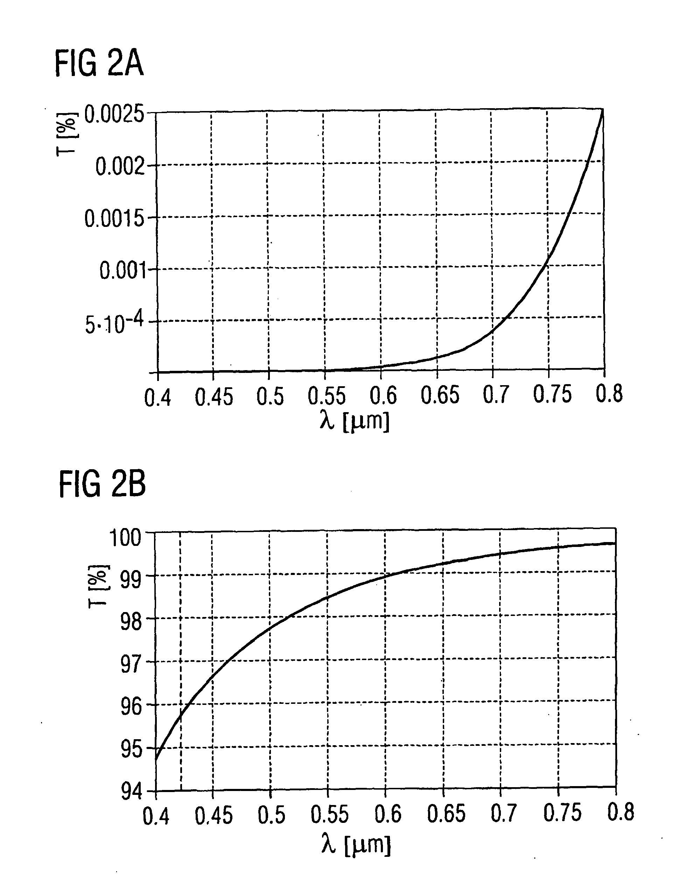

Für ein derartiges Filterelement 1 ist in Figur 2b die Transmission elektromagnetischer Strahlung unter ausschließlicher Berücksichtigung von Streuung in Abhängigkeit von der Wellenlänge der Strahlung dargestellt. Die Transmission beträgt bei einer Wellenlänge von etwa 400 nm ungefähr 95 % und steigt mit zunehmender Wellenlänge auf einen Wert von über 99 % bei etwa 700 nm. Somit sind Verluste an Strahlungsintensität aufgrund von Streuung an den Nanopartikeln 2 des Filterelementes 1 sehr gering.

In Figur 2a ist ebenfalls die Transmission für ein Filterelement mit einer 50 *µ*m dicken Schicht die ca. 15 Gew.% Titandioxid in der Rutil-Modifikation aufweist, mit dem einzigen Unterschied, dass das Titandioxid in Form von Partikeln mit einer Partikelgröße von etwa 10 *µ*m vorliegt. Ein derartiges Filterelement ist für den gesamten sichtbaren Wellenlängenbereich praktisch nicht transparent.

Berücksichtigt man bei dem Filterelement 1, das dem in Figur 2b dargestellten Transmissionsspektrum zugrunde liegt, zusätzlich zu der Streuung noch die Absorption im Titandioxid, so ergibt sich für eine Wellenlänge von kleiner als ungefähr 420 nm eine deutlich reduzierte Transmission. Bei einer Strahlung der Wellenlänge 412 nm beträgt die Transmission nur mehr etwa 1 %. Somit kann eine für die Augen schädliche und deshalb unerwünschte Strahlung wie etwa die Primärstrahlung aus dem UV- und/oder kurzwelligen blauen Bereich wirkungsvoll reduziert werden, ohne dass eine allzu hohe Verringerung der Strahlungsintensität einer erwünschten Strahlung in Kauf genommen werden muß.

Die Streuung der von dem Bauelement zu emittierenden Strahlung an den Nanopartikeln des Filterelementes führt vorteilhafterweise zu deren verbesserten Durchmischung, insbesondere zu einer verbesserten Durchmischung von Licht unterschiedlicher Farbe.

Alternativ zu einem Metalloxid wie etwa einem Titandioxid können in den Ausführungsbeispielen alternativ oder zusätzlich auch weitere geeignete Metalloxide, oder geignete Sulfide, Nitride und/oder Silikate als Filtersubstanz verwendet werden. Hierzu eignen sich beispielsweise die Materialien Cerdioxid, Zirkoniumdioxid, Zinkoxid, Wolframoxid, Zinksulfid und Galliumnitrid, die hinsichtlich einer unerwünschten Strahlung, d.h. hinsichtlich ihrer absorbierenden Eigenschaften ausgewählt werden. Auch die Menge an Nanopartikeln wird entsprechend einer gewünschten Verringerung der Intensität der absorbierten Strahlung unter Berücksichtigung des jeweiligen (wellenlängenabhängigen) Absorptionskoeffizienten angepasst.

Grundsätzlich sind im Rahmen der Erfindung für einen Bestandteil der Filtersubstanz alle Materialien geeignet, die für Licht aus einem sichtbaren Wellenlängenbereich transparent sind und die für eine unerwünschte Strahlung der Primärstrahlungsquelle, insbesondere für eine Strahlung aus dem UV- und/oder violetten Bereich absorbierend sind.

Die Nanopartikel weisen eine dispersionsfördernde Oberflächenbeschichtung oder eine dispersionsfördernde Oberflächenmodifikation auf, d.h. sie sind mit geeigneten Molekülen beschichtet oder derartige Moleküle sind an ihnen adsorbiert, so dass ihre Dispergierbarkeit in dem Matrixmaterial verbessert.

Der Schutzumfang der Erfindung ist nicht durch die Beschreibung der Erfindung anhand der Ausführungsbeispiele beschränkt.

## Patentansprüche

1. Licht emittierendes Bauelement mit
- mindestens einer Primärstrahlungsquelle (6), die bei Betrieb eine elektromagnetische Primärstrahlung emittiert, und
- mindestens einem Lumineszenz-Konversionselement (5), mittels dem zumindest ein Teil der Primärstrahlung in eine Strahlung von veränderter Wellenlänge konvertiert wird,
- einem dem Lumineszenz-Konversionselement (5) in einer Abstrahlrichtung des Bauelementes nachgeordneten Filterelement (1)
**dadurch gekennzeichnet, dass**
das Filterelement (1) eine Vielzahl von Nanopartikeln (2) mit einem mittleren Partikeldurchmesser von größer oder gleich 0,1 nm und kleiner oder gleich 100 nm aufweisst, wobei die Nanopartikel (2) in einem Matrixmaterial (3) eingebettet sind und eine dispersionsfördernde Oberflächenbeschichtung oder eine dispersionsfördernde Oberflächenmodifikation und eine Filtersubstanz aufweisen, die eine Strahlungsintensität zumindest eines spektralen Teilbereichs einer unerwünschten Strahlung der Primärstrahlungsquelle (6) durch Absorption selektiv verringert.

2. Bauelement nach Anspruch 1,
**dadurch gekennzeichnet, dass**
die unerwünschte Strahlung aus einem Wellenlängenbereich größer oder gleich 10 nm und kleiner oder gleich 420 nm stammt oder mit diesem überlappt.

3. Bauelement nach einem der vorhergehenden Ansprüche,
**dadurch gekennzeichnet, dass**
die Primärstrahlungsquelle (6) mindestens eine Lumineszenzdiode aufweist, die bei Betrieb UV-Strahlung und/oder blaues Licht emittiert.

4. Bauelement nach einem der vorhergehenden Ansprüche,
**dadurch gekennzeichnet, dass**
die Strahlungsintensität des spektralen Teilbereichs der unerwünschten Strahlung um mindestens 50 % verringert wird.

5. Bauelement nach einem der vorhergehenden Ansprüche,
**dadurch gekennzeichnet, dass**
die Nanopartikel (2) einen d₅₀-Wert aufweisen, der, in Q₀ gemessen, kleiner oder gleich 25 nm und größer oder gleich 1 nm ist.

6. Bauelement nach einem der vorhergehenden Ansprüche,
**dadurch gekennzeichnet, dass**
die Nanopartikel (2) einen d₅₀-Wert aufweisen, der, in Q₀ gemessen, kleiner oder gleich 21 nm und größer oder gleich 1 nm ist.

7. Bauelement nach einem der vorhergehenden Ansprüche,
**dadurch gekennzeichnet, dass**
die Nanopartikel (2) einen d₅₀-Wert aufweisen, der, in Q₀ gemessen, kleiner oder gleich ein Zwanzigstel einer minimalen Wellenlänge einer erwünschten Strahlung und größer oder gleich 1 nm ist.

8. Bauelement nach einem der vorhergehenden Ansprüche,
**dadurch gekennzeichnet, dass**
die Filtersubstanz mindestens ein Material aus der Gruppe bestehend aus der Materialgruppe der Metalloxide, der Materialgruppe der Sulfide, der Materialgruppe der Nitride und der Materialgruppe der Silikate aufweist.

9. Bauelement nach Anspruch 8,
**dadurch gekennzeichnet, dass**
die Filtersubstanz mindestens ein Material aus der Gruppe bestehend aus Titandioxid, Cerdioxid, Zirkoniumdioxid, Zinkoxid, Wolframoxid, Zinksulfid und Galliumnitrid aufweist.

10. Bauelement nach Anspruch 1,
**dadurch gekennzeichnet, dass**
das Matrixmaterial (3) unempfindlich gegenüber UV-Strahlung ist.

11. Bauelement nach Anspruch 10,
**dadurch gekennzeichnet, dass**
das Matrixmaterial (3) mindestens ein Material aus der Gruppe bestehend aus Silikon, Spin-on-Gläser, Silicium-Verbindung und Polymer aufweist.

## Claims

1. Light-emitting component comprising
- at least one primary radiation source (6) which emits an electromagnetic primary radiation during operation, and
- at least one luminescence conversion element (5) by means of which at least part of the primary radiation is converted into a radiation of changed wavelength,
- a filter element (1) disposed downstream of the luminescence conversion element (5) in an emission direction of the component,
**characterized in that**
the filter element (1) comprises a multiplicity of nanoparticles (2) having an average particle diameter of greater than or equal to 0.1 nm and less than or equal to 100 nm, wherein the nanoparticles (2) are embedded in a matrix material (3) and have a dispersion-promoting surface coating or a dispersion-promoting surface modification and a filter substance which selectively reduces a radiation intensity of at least one spectral subrange of an undesired radiation of the primary radiation source (6) by absorption.

2. Component according to Claim 1,
**characterized in that**
the undesired radiation originates from or overlaps a wavelength range of greater than or equal to 10 nm and less than or equal to 420 nm.

3. Component according to either of the preceding claims,
**characterized in that**
the primary radiation source (6) comprises at least one luminescence diode which emits UV radiation and/or blue light during operation.

4. Component according to any of the preceding claims,
**characterized in that**
the radiation intensity of the spectral subrange of the undesired radiation is reduced by at least 50%.

5. Component according to any of the preceding claims,
**characterized in that**
the nanoparticles (2) have a d₅₀ value which, measured in Q₀, is less than or equal to 25 nm and greater than or equal to 1 nm.

6. Component according to any of the preceding claims,
**characterized in that**
the nanoparticles (2) have a d₅₀ value which, measured in Q₀, is less than or equal to 21 nm and greater than or equal to 1 nm.

7. Component according to any of the preceding claims,
**characterized in that**
the nanoparticles (2) have a d₅₀ value which, measured in Q₀, is less than or equal to one twentieth of a minimum wavelength of a desired radiation and is greater than or equal to 1 nm.

8. Component according to any of the preceding claims,
**characterized in that** the filter substance comprises at least one material from the group consisting of the material group of the metal oxides, the material group of the sulphides, the material group of the nitrides and the material group of the silicates.

9. Component according to Claim 8,
**characterized in that**
the filter substance comprises at least one material from the group consisting of titanium dioxide, cerium dioxide, zirconium dioxide, zinc oxide, tungsten oxide, zinc sulphide and gallium nitride.

10. Component according to Claim 1,
**characterized in that**
the matrix material (3) is insensitive to UV radiation.

11. Component according to Claim 10,
**characterized in that**
the matrix material (3) comprises at least one material from the group consisting of silicone, spin-on glasses, silicon compound and polymer.

## Revendications

1. Composant émetteur de lumière comprenant
- au moins une source de rayonnement primaire (6) qui, lors du fonctionnement, émet un rayonnement primaire électromagnétique, et
- au moins un élément de conversion de luminescence (5) au moyen duquel au moins une partie du rayonnement primaire est convertie en un rayonnement ayant une longueur d'onde modifiée,
- un élément filtrant (1) disposé à la suite de l'élément de conversion de luminescence (5) dans un sens de rayonnement du composant,
**caractérisé en ce que**
l'élément filtrant (1) présente une pluralité de nanoparticules (2) ayant un diamètre de particule moyen supérieur ou égal à 0,1 nm et inférieur ou égal à 100 nm, les nanoparticules (2) étant enrobées dans un matériau matriciel (3) et présentant un revêtement de surface favorisant la dispersion ou une modification de la surface favorisant la dispersion et une substance filtrante qui réduit sélectivement par absorption une intensité de rayonnement d'au moins une plage spectrale partielle d'un rayonnement non désiré de la source de rayonnement primaire (6).

2. Composant selon la revendication 1, **caractérisé en ce que** le rayonnement non désiré est issu d'une plage de longueurs d'onde supérieure ou égale à 10 nm et inférieure ou égale à 420 nm ou chevauche celle-ci.

3. Composant selon l'une des revendications précédentes, **caractérisé en ce que** la source de rayonnement primaire (6) présente au moins une diode luminescente qui, lors du fonctionnement, émet un rayonnement UV et/ou de la lumière bleue.

4. Composant selon l'une des revendications précédentes, **caractérisé en ce que** l'intensité de rayonnement de la plage spectrale partielle du rayonnement non désiré est réduite d'au moins 50 %.

5. Composant selon l'une des revendications précédentes, **caractérisé en ce que** les nanoparticules (2) présentent une valeur d₅₀ qui, mesurée en Q₀, est inférieure ou égale à 25 nm et supérieure ou égale à 1 nm.

6. Composant selon l'une des revendications précédentes, **caractérisé en ce que** les nanoparticules (2) présentent une valeur d₅₀ qui, mesurée en Q₀, est inférieure ou égale à 21 nm et supérieure ou égale à 1 nm.

7. Composant selon l'une des revendications précédentes, **caractérisé en ce que** les nanoparticules (2) présentent une valeur d₅₀ qui, mesurée en Q₀, est inférieure ou égale à un vingtième d'une longueur d'onde minimale d'un rayonnement souhaité et supérieure ou égale à 1 nm.

8. Composant selon l'une des revendications précédentes, **caractérisé en ce que** la substance filtrante présente au moins un matériau du groupe composé du groupe de matériaux des oxydes métalliques, du groupe de matériaux des sulfures, du groupe de matériaux des nitrures et du groupe de matériaux des silicates.

9. Composant selon la revendication 8, **caractérisé en ce que** la substance filtrante présente au moins un matériau du groupe composé du dioxyde de titane, du dioxyde de cérium, du dioxyde de zirconium, de l'oxyde de zinc, de l'oxyde de tungstène, du sulfure de zinc et du nitrure de gallium.

10. Composant selon la revendication 1, **caractérisé en ce que** le matériau matriciel (3) est insensible au rayonnement UV.

11. Composant selon la revendication 10, **caractérisé en ce que** le matériau matriciel (3) présente au moins un matériau du groupe composé du silicium, des verres de spin, d'une combinaison de silicium et du polymère.
